# EUROPEAN PATENT APPLICATION

(11) **EP 4 255 137 A1**
(43) Date of publication of application: **04.10.2023**
(21) Application number: 22165456.9
(22) Date of filing: 30.03.2022
(51) Int. Cl.: H05K 7/00

(54) **A THERMAL PAD ADAPTED TO CONDUCT HEAT FROM AN ELECTRONIC COMPONENT**

(71) Applicant: Veoneer Sweden AB, 447 37 Vårgårda (SE)
(72) Inventor: FREDRIKSSON, Peter, 447 37 Vårgårda (SE)
(74) Representative: Westpatent AB

(57) **Abstract**

The present disclosure relates to thermal pad (200) adapted to conduct heat from an electronic component (113), where the thermal pad (200) is made in a compressible material and comprises a first main side (201) and a second main side (202). The first main side (201) is adapted to face an electronic component (113) and the second main side (202) is adapted to face a structure (203) that is adapted to absorb heat from the thermal pad (202). The thermal pad (200) further comprises a plurality of apertures (204) that run between the first main side (201) and the second main side (202), where the apertures (204) are adapted to deform such that a volume (V) of each aperture (204) is decreased when the thermal pad (200) is compressed such that a first shortest distance (h₁) between the first main side (201) and the second main side (202) decreases to a second shortest distance (h₂) between the first main side (201) and the second main side (202).

## Description

### DESCRIPTION OF THE DISCLOSURE

The present disclosure relates to a thermal pad adapted to conduct heat from an electronic component and is made in a compressible material. A first main side is adapted to face an electronic component, and a second main side is adapted to face a structure that is adapted to absorb heat from the thermal pad.

Many vehicle environment detection systems comprise one or more sensors such as for example radar sensor, LIDAR sensors, ultrasonic sensors and digital camera devices. These are used for collecting data used for safety arrangements as well as for driver assistance systems. A camera device is adapted to collect images of the surroundings, and may be used to identify landmarks.

For a digital camera device, that can be in the form of, or comprised in, a vehicle imaging system, a camera module is mounted to a camera housing. The camera module comprises a lens assembly and a PCB to which an image sensor and associated components are mounted.

Generally, thermal pads are used to transfer heat from heat-generating components or PCB assemblies to heatsinks or housing components. In order to handle mechanical tolerances while ensuring good heat transfer, the thermal pad needs to be able to be compressed between the parts. Since a thermal pad is more or less solid, compared to a thermal paste or gel, this results in a force that increases with the compression. A solid thermal pad can have a number of advantages over a paste or gel, especially in optical systems sensitive to bleeding or outgassing. Thermal pads are often die cut to shape.

In camera systems there is a need for a thermal pad to handle a considerable mechanical tolerance while having as low variation in the compression force as possible. This can be used between a PCB and a metal back cover equipped with cooling fins, but more notably between the PCB carrying the image sensor and the lens holder in a camera using active alignment (where the force if excessive interferes with the alignment and glue curing)

In digital camera devices there is a need for thermal pad to handle a considerable mechanical tolerance while having as low variation in the compression force as possible. This can be used between a PCB and a metal back cover equipped with cooling fins, but more notably between the PCB carrying the image sensor and the lens holder in a camera using active alignment, where the force if excessive interferes with the alignment and glue curing.

It is therefore desired to provide a thermal pad that can meet the above requirements in an efficient and cost-effective manner.

Said object is achieved by means of a thermal pad adapted to conduct heat from an electronic component, where the thermal pad is made in a compressible material and comprises a first main side and a second main side. The first main side is adapted to face an electronic component and the second main side is adapted to face a structure that is adapted to absorb heat from the thermal pad. The thermal pad further comprises a plurality of apertures that run between the first main side and the second main side. The apertures are adapted to deform such that a volume of each aperture is decreased when the thermal pad is compressed such that a first shortest distance between the first main side and the second main side decreases to a second shortest distance between the first main side and the second main side.

This means that the thermal pad can handle a considerable mechanical tolerance while having as low variation in the compression force as possible. The apertures add to the compressibility and can for example be added in a die cut process with low extra cost. This gives the material space to compress locally, without having to deform the thermal pad globally.

According to some aspects, the thermal pad is adapted to be mounted on a second component side of a printed circuit board (PCB) opposite a first component side that is adapted to carry an electronic component such that the first main side is adapted to face the electronic component via the PCB.

This means that heat can be efficiently transferred away from the electronic component via the thermal pad.

According to some aspects, the structure that is adapted to absorb heat from the thermal pad is a cooling flange, where the second main side is adapted to be mounted to the cooling flange.

This means that heat can be efficiently transferred away from the electronic component via the thermal pad.

According to some aspects, the electronic component is an image sensor comprised in a vehicle camera module.

This means that the thermal pad is suited for transferring heat away from the image sensor.

According to some aspects, the apertures are arranged in a first plurality of rows and a second plurality of columns.

This means that the thermal pad can be compressed in a uniform manner.

This object is also achieved by means of printed circuit board (PCB) arrangements, vehicle camera modules and methods associated with the above advantages.

### BRIEF DESCRIPTION OF THE DRAWINGS

The present disclosure will now be described more in detail with reference to the appended drawings, where:
- Figure 1: shows a schematic cut-open part of a vehicle with a camera device;
- Figure 2: shows a schematic perspective front view of a vehicle camera module according to a first example;
- Figure 3: shows an exploded perspective view of the vehicle camera module;
- Figure 4: shows a schematic top view of a thermal pad;
- Figure 5: shows a schematic section view of the thermal pad;
- Figure 6: shows a schematic cut-open view of a PCB arrangement according to a first example, and a part of a lens assembly, before mounting;
- Figure 7: shows a schematic cut-open view of the PCB arrangement according to the first example, and a part of the lens assembly, when mounted;
- Figure 8: shows a schematic cut-open view of a thermal pad and a PCB with an electronic component according to a second example before mounting;
- Figure 9: shows a schematic cut-open view of a PCB arrangement according to the second example when mounted;
- Figure 10: shows a schematic cut-open view of a PCB arrangement according to a third example before mounting;
- Figure 11: shows a schematic cut-open view of a PCB arrangement according to the third example when mounted; and
- Figure 12: shows a flowchart for methods according to the present disclosure.

### DETAILED DESCRIPTION

Aspects of the present disclosure will now be described more fully hereinafter with reference to the accompanying drawings. The different devices, systems, computer programs and methods disclosed herein can, however, be realized in many different forms and should not be construed as being limited to the aspects set forth herein. Like numbers in the drawings refer to like elements throughout.

The terminology used herein is for describing aspects of the disclosure only and is not intended to limit the invention. As used herein, the singular forms "a", "an" and "the" are intended to include the plural forms as well, unless the context clearly indicates otherwise.

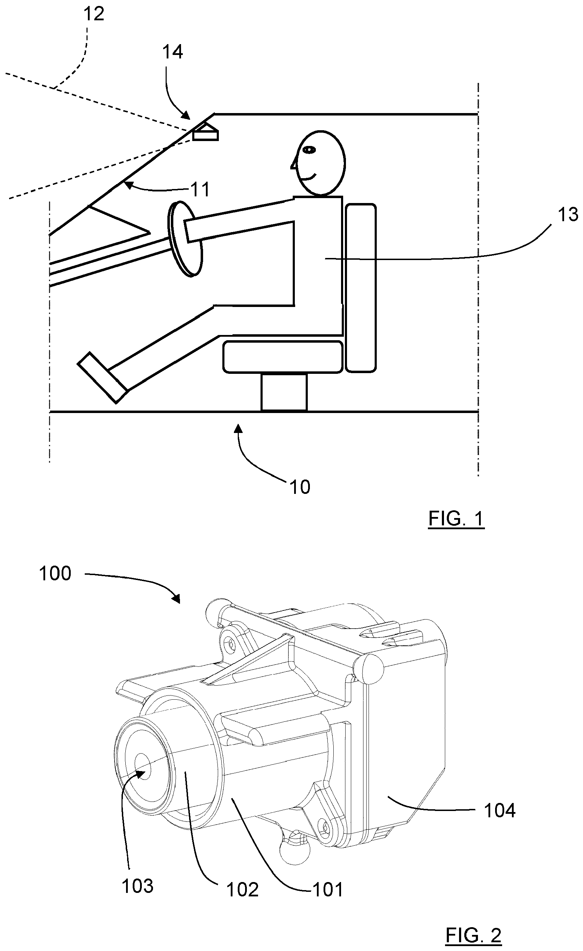

Figure 1 schematically shows a cut-open part of a vehicle 10, where the vehicle 10 comprises a vehicle camera arrangement 14 attached to a vehicle windscreen 11. The vehicle camera arrangement 14 is arranged for capturing images of the surroundings outside the vehicle 10 by means of a certain field of view 12. The vehicle camera arrangement 14 can also, or alternatively, be arranged for capturing images of a driver 13, where these images, which may include eye movements, for example can be used for detecting a degree of driver drowsiness.
Figure 2 shows a side perspective view of a vehicle camera module 100 that is comprised in the vehicle camera arrangement 14, and

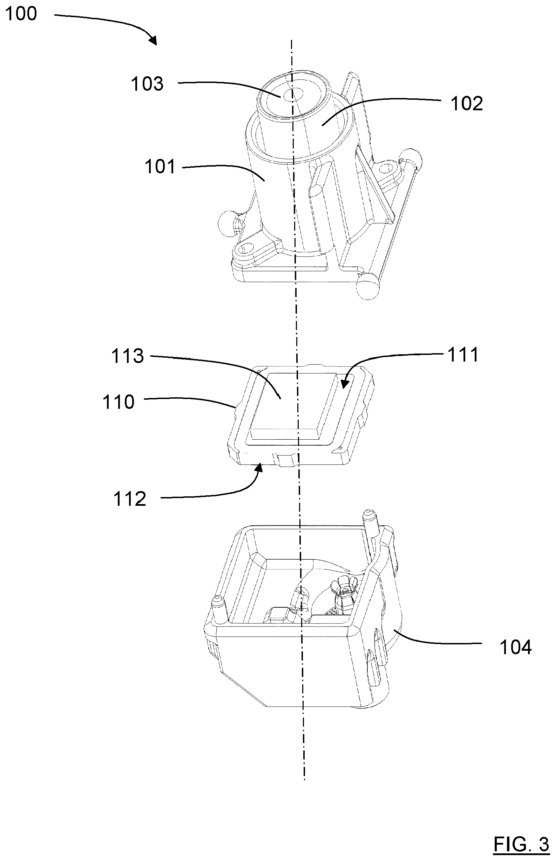

Figure 3 shows an exploded perspective views of the vehicle camera module 100.

The vehicle camera module 100 comprises a lens assembly 101. According to some aspects, the vehicle camera module 100 comprises a lens barrel 102, a lens aperture 103, and a cover part 104 that is adapted to be mounted to the lens assembly 101. A gasket (not shown) can be added to provide sealing between the lens assembly 101 and the cover part 104.

The vehicle camera module 100 further comprises a PCB 110 with a first component side 111 and a second component side 112, where an electronic component 113 is mounted to the first component side 111.

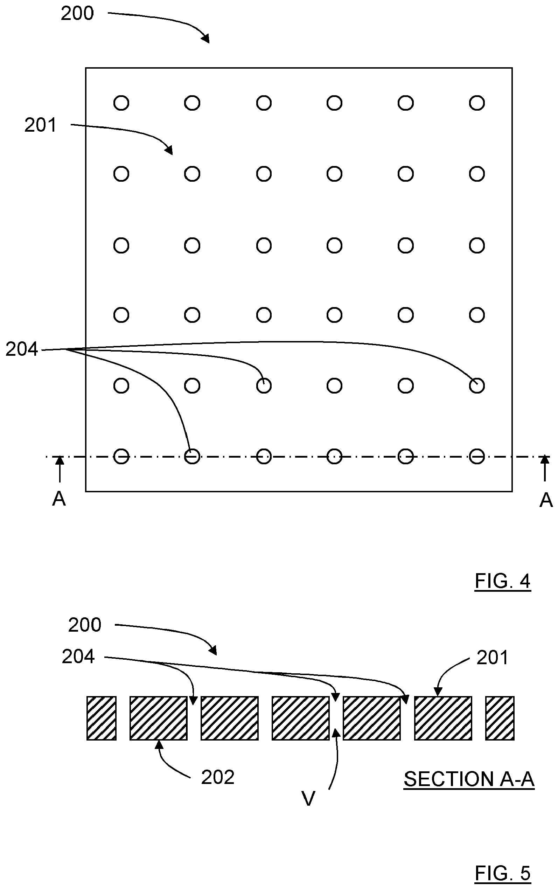

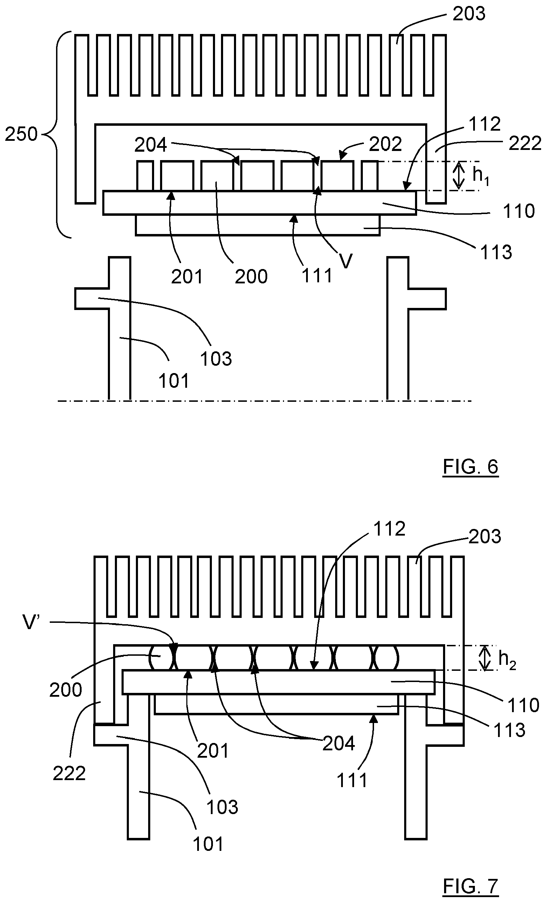

The following refers to Figure 4 - Figure 7, where Figure 4 shows a schematic top view of a thermal pad, Figure 5 shows a schematic section view of the thermal pad, Figure 6 shows a schematic cut-open view of a PCB arrangement 250 according to a first example, and a part of a lens assembly, before mounting, and where Figure 7 shows a schematic cut-open view of the PCB arrangement 250 according to the first example, and a part of the lens assembly, when mounted.

The vehicle camera module 100 further comprises a thermal pad 200 adapted to conduct heat from the electronic component 113, where the thermal pad 200 is made in a compressible material and comprises a first main side 201 and a second main side 202. The first main side 201 is adapted to face the electronic component 113 and the second main side 202 is adapted to face a structure 203 that is adapted to absorb heat from the thermal pad 202.

According to some aspects, this means that the first main side 201 does not need to be adapted to be in direct contact with the electronic component 113, although it is not excluded that the first main side 201 is adapted to be in direct contact with the electronic component 113. According to some aspects, this also means that the second main side 202 does not need to be adapted to be in direct contact with the structure 203 that is adapted to absorb heat from the thermal pad 202, although it is not excluded that the second main side 202 is adapted to be in direct contact with the structure 203 that is adapted to absorb heat from the thermal pad 202.

According to some aspects, the structure 203 that is adapted to absorb heat from the thermal pad 202 is a cooling flange 203, where the second main side 202 is adapted to be mounted to the cooling flange 203.

According to the present disclosure, the thermal pad 200 further comprises a plurality of apertures 204 (only a few indicated in the Figures for reasons of clarity) that run between the first main side 201 and the second main side 202. The apertures 204 are adapted to deform such that a volume V of each aperture 204 is decreased when the thermal pad 200 is compressed such that a first shortest distance h₁ between the first main side 201 and the second main side 202 decreases to a second shortest distance h₂ between the first main side 201 and the second main side 202.

This is illustrated in Figure 6 and Figure 7, where the volume V is decreased to a smaller volume V' when the thermal pad 200 is compressed. In this context, each aperture 204 is defined as a cylinder or other geometric body, which can be symmetric or asymmetric, extending between the first main side 201 and the second main side 202. The volume V is the volume of an aperture 204 that extends between the first main side 201 and the second main side 202. The volume V and the smaller volume V' can of course differ between different apertures 204 in the same thermal pad 200.

This means that the thermal pad 200 can handle a considerable mechanical tolerance while having as low variation in the compression force as possible. The apertures 204 add to the compressibility and can for example be added in a die cut process with low extra cost. This gives the material space to compress locally, without having to deform the thermal pad 200 globally.

According to some aspects, the thermal pad 200 is adapted to be mounted on the second component side 112 of the PCB 110, opposite the first component side 111 that is adapted to carry an electronic component 113, such that the first main side 201 is adapted to face the electronic component 113 via the PCB 110.

This means that heat can be efficiently transferred away from the electronic component 113 via the thermal pad 200.

According to some aspects, the electronic component 113 is an image sensor comprised in a vehicle camera module 100. This means that the thermal pad 200 is suited for transferring heat away from the image sensor 113.

According to some aspects, the apertures 204 are arranged in a first plurality of rows and a second plurality of columns. This means that the thermal pad can be compressed in a uniform manner.

According to some aspects, the thermal pad 200 is made in silicone. This means that the thermal pad 200 can be made in a conventional material, using conventional manufacturing methods.

The present disclosure relates to the thermal pad 104 as described above.

The present disclosure also relates to a PCB arrangement comprising the PCB 110 according to the above, the thermal pad 200 according to the above, and a structure 203 that is adapted to absorb heat from the thermal pad 202, where the structure 203 is mounted to the second main side 202 of the thermal pad 202.

According to some aspects, the electronic component is either an image sensor 113 or a processor integrated circuit 430.

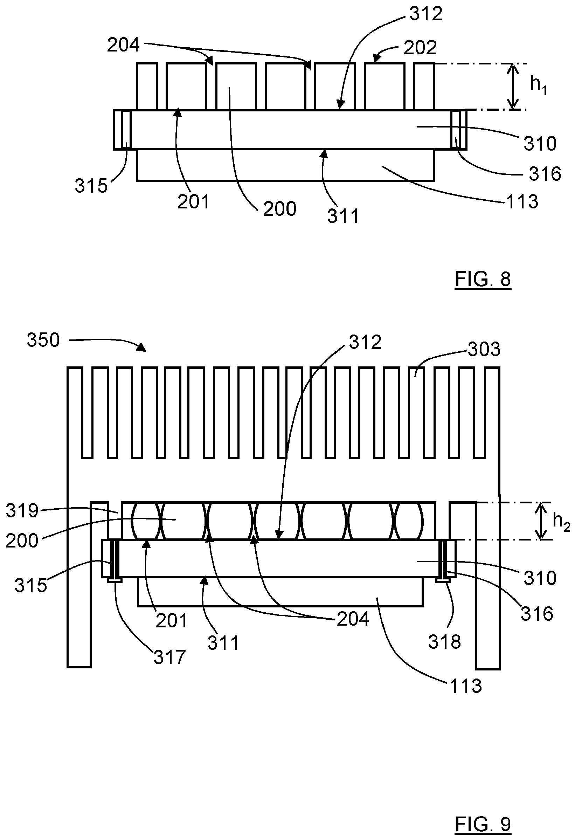

Figure 8 shows a schematic cut-open view of a thermal pad and a PCB with an electronic component according to a second example before mounting, and Figure 9 shows a schematic cut-open view of a PCB arrangement 350 according to the second example when mounted. According to some aspects, with reference to Figure 6-9, where, the thermal pad 200 is mounted to the second component side 112, 312. In this way, the PCB 110, 310 is positioned between the electronic component 113 and the thermal pad 200.

This can be realized in many ways. According to some aspects, as shown in Figure 6-7, illustrating the first example of a PCB arrangement 250, the thermal pad is sandwiched between the PCB 110 and the structure 203 that is adapted to absorb heat from the thermal pad 202.

Here, according to a further aspect of the present disclosure, the camera module 100 comprises the PCB arrangement 250, the lens assembly 101 and the cover part 104 as mentioned above. The lens assembly 101 further comprises an at least partly circumferentially running flange rim 103, where the structure 403 that is adapted to absorb heat from the thermal pad 202 is a cooling flange that comprises an at least partly circumferentially running mounting flange 222 that is adapted to be attached to the flange rim 103. In this way, a first shortest distance h₁ between the first main side 201 and the second main side 202 decreases to a second shortest distance h₂ between the first main side 201 and the second main side 202 when the mounting flange 222 is attached to the flange rim 103.

This means that the lens assembly 101 can be used to press the PCB 110 towards the cooling flange 403 such that the thermal pad is 200 is pressed against the cooling flange 403 and compressed. The apertures 204 then deform such that the volume V of each aperture 204 is decreased.

According to some aspects, as shown in Figure 8-9, illustrating the third example of the PCB arrangement 350, the PCB 310 comprises PCB apertures 315, 316 running between the first component side 311 and the second component side 312. The structure 303 that is adapted to absorb heat from the thermal pad 202 is a cooling flange that comprises an internally threaded at least partly circumferentially running fastening rim 319. The rim 319 is adapted to receive mounting screws 317, 318 that run via the PCB apertures 315, 316 and are adapted to mount the PCB 310 to the cooling flange 303 such that a first shortest distance h₁ between the first main side 201 and the second main side 202 decreases to a second shortest distance h₂ between the first main side 201 and the second main side 202.

In this way, the PCB 310 can be securely mounted to the cooling flange 103.

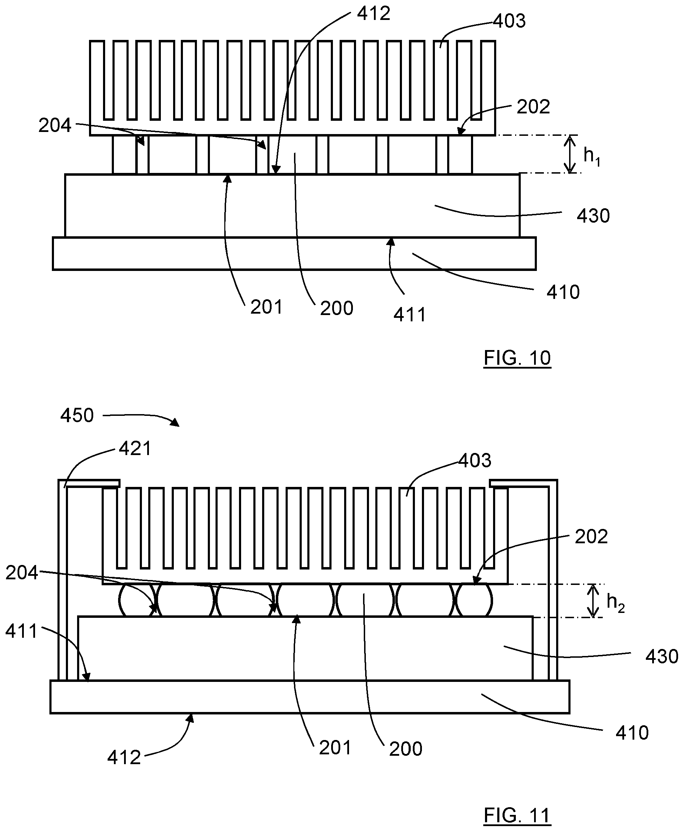

With reference to Figure 10 that shows a schematic cut-open view of a PCB arrangement 450 according to a third example before mounting and Figure 11 that shows a schematic cut-open view of a PCB arrangement according to the third example when mounted, the electronic component is a processor integrated circuit 430. The first component side 311 faces the processor integrated circuit 430 that is positioned between the thermal pad 200 and the PCB 310, where the structure 403 that is adapted to absorb heat from the thermal pad 202 is a cooling flange.

The PCB arrangement 450 further comprises a holding arrangement 421 that is attached to the PCB 410 and is adapted to engage the cooling flange 403 such that the cooling flange 403 is pressed towards the PCB 410. By means of the pressing, a first shortest distance h₁ between the first main side 201 and the second main side 202 decreases to a second shortest distance h₂ between the first main side 201 and the second main side 202.

This provides a direct connection from the processor integrated circuit 430 to the cooling flange 403 via the thermal pad 200, and thus efficient cooling of the processor integrated circuit 430.

The present disclosure also relates to a vehicle camera module 100 comprising the PCB arrangement 250, 350, 450 according to the above, a lens assembly 101 and a cover part 104.

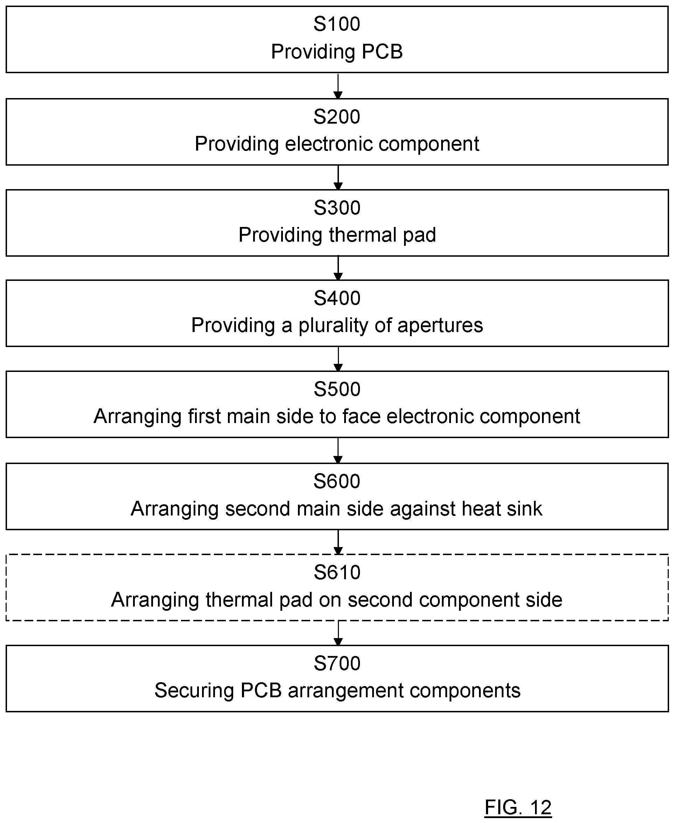

With reference to Figure 12, the present disclosure also relates to a method for mounting a printed circuit board, PCB, arrangement 250, 350. The method comprises providing S100 a PCB 110, 310 with a first component side 111, 311 and a second component side 112, 312, providing S200 an electronic component 113 mounted to the first component side 111, 311, and providing S300 a thermal pad 200 made in a compressible material with a first main side 201 and a second main side 202.

The method further comprises providing S400 a plurality of apertures 204 that run between the first main side 201 and the second main side 202 in the thermal pad 200, where the apertures 204 are adapted to deform such that a volume V of each aperture 204 is decreased when the thermal pad 200 is compressed such that the first main side 201 is pressed towards the second main side 202. The method also comprises arranging S500 the first main side 201 to face the electronic component 113, arranging S600 the second main side 202 against a cooling flange 203, 303 that is adapted to absorb heat from the thermal pad 202, and securing S700 the components of the PCB arrangement 250, 350 by pressing the thermal pad 200 between the PCB 110, 310 and the cooling flange 203, 303, such that a first shortest distance h₁ between the first main side 201 and the second main side 202 decreases to a second shortest distance h₂ between the first main side 201 and the second main side 202.

According to some aspects, the method comprises arranging S610 the thermal pad 200 on the second component side 112, 312 of the PCB 110, 310.

According to some aspects, the method described above is related to the first example and second example described above with reference to Figure 6-9.

The present disclosure is not limited to the examples above, but may vary freely within the scope of the appended claims. As mentioned above, each aperture 204 is defined as a cylinder or other geometric body extending between the first main side 201 and the second main side 202. For example, such geometric bodies can have a square, oval, rectangular or polygonal cross-section. The cross-section need not be uniformly shaped when running between the first main side 201 and the second main side 202.

A thermal pad 200 may comprise apertures 204 of different sizes and/or shapes, having different volumes in an uncompressed state.

According to some aspects, the aperture 204 may be distributed evenly in a certain pattern or unevenly, for example in different patterns or randomized patters.

## Claims

1. A thermal pad (200) adapted to conduct heat from an electronic component (113), where the thermal pad (200) is made in a compressible material and comprises a first main side (201) and a second main side (202), where the first main side (201) is adapted to face an electronic component (113) and the second main side (202) is adapted to face a structure (203) that is adapted to absorb heat from the thermal pad (202), **characterized in that** the thermal pad (200) further comprises a plurality of apertures (204) that run between the first main side (201) and the second main side (202), where the apertures (204) are adapted to deform such that a volume (V) of each aperture (204) is decreased when the thermal pad (200) is compressed such that a first shortest distance (h₁) between the first main side (201) and the second main side (202) decreases to a second shortest distance (h₂) between the first main side (201) and the second main side (202).

2. The thermal pad (200) according to claim 1, wherein the thermal pad (200) is adapted to be mounted on a second component side (112) of a printed circuit board, PCB (110), opposite a first component side (111) that is adapted to carry an electronic component (113) such that the first main side (201) is adapted to face the electronic component (113) via the PCB (110).

3. The thermal pad (200) according to any one of the claims 1 or 2, wherein the structure (203) that is adapted to absorb heat from the thermal pad (202) is a cooling flange (203), where the second main side (202) is adapted to be mounted to the cooling flange (203).

4. The thermal pad (200) according to any one of the previous claims, wherein the electronic component (113) is an image sensor comprised in a vehicle camera module (100).

5. The thermal pad (200) according to any one of the previous claims, wherein the apertures (204) are arranged in a first plurality of rows and a second plurality of columns.

6. A printed circuit board, PCB, arrangement (250) comprising a PCB (110) with a first component side (111) and a second component side (112), an electronic component (113) mounted to the first component side (111), a thermal pad (200) according to any one of the claims 1-5, and a structure (203) that is adapted to absorb heat from the thermal pad (202), where the structure (203) is mounted to the second main side (202) of the thermal pad (202).

7. The PCB arrangement according to claim 6, wherein the electronic component is an image sensor (113).

8. The PCB arrangement according to claim 6, wherein the electronic component is a processor integrated circuit (430).

9. The PCB arrangement (250, 350) according to any one of the claims 6-8, wherein the thermal pad (200) is mounted to the second component side (112, 312) such that the PCB (110, 310) is positioned between the electronic component (113) and the thermal pad (200).

10. The PCB arrangement (350) according to any one of the claims 6-9, wherein the PCB (310) comprises PCB apertures (315, 316) running between the first component side (311) and the second component side (312), and where the structure (303) that is adapted to absorb heat from the thermal pad (202) is a cooling flange that comprises an internally threaded at least partly circumferentially running fastening rim (319) that is adapted to receive mounting screws (317, 318) that run via the PCB apertures (315, 316) and are adapted to mount the PCB (310) to the cooling flange (303) such that a first shortest distance (h₁) between the first main side (201) and the second main side (202) decreases to a second shortest distance (h₂) between the first main side (201) and the second main side (202).

11. The PCB arrangement (450) according to claim 8, wherein the first component side (311) faces the processor integrated circuit (430) that is positioned between the thermal pad (200) and the PCB (310), where the structure (403) that is adapted to absorb heat from the thermal pad (202) is a cooling flange, where the PCB arrangement (450) further comprises a holding arrangement (421) that is attached to the PCB (410) and is adapted to engage the cooling flange (403) such that the cooling flange (403) is pressed towards the PCB (410) such that a first shortest distance (h₁) between the first main side (201) and the second main side (202) decreases to a second shortest distance (h₂) between the first main side (201) and the second main side (202) .

12. A vehicle camera module (100) comprising the PCB arrangement (250, 350, 450) according to any one of the claims 6-11, a lens assembly (101) and a cover part (104).

13. A vehicle camera module (100) comprising the PCB arrangement (250) according to claim 9, a lens assembly (101) and a cover part (104), where the lens assembly (101) comprises an at least partly circumferentially running flange rim (103), where the structure (403) that is adapted to absorb heat from the thermal pad (202) is a cooling flange that comprises an at least partly circumferentially running mounting flange (222) that is adapted to be attached to the flange rim (103)', such that a first shortest distance (h₁) between the first main side (201) and the second main side (202) decreases to a second shortest distance (h₂) between the first main side (201) and the second main side (202) when the mounting flange (222) is attached to the flange rim (103).

14. A method for mounting a printed circuit board, PCB, arrangement (250, 350), where the method comprises
providing (S100) a PCB (110, 310) with a first component side (111, 311) and a second component side (112, 312);
providing (S200) an electronic component (113) mounted to the first component side (111, 311);
providing (S300) a thermal pad (200) made in a compressible material with a first main side (201) and a second main side (202);
wherein the method further comprises
providing (S400) a plurality of apertures (204) that run between the first main side (201) and the second main side (202) in the thermal pad (200), where the apertures (204) are adapted to deform such that a volume (V) of each aperture (204) is decreased when the thermal pad (200) is compressed such that the first main side (201) is pressed towards the second main side (202);
arranging (S500) the first main side (201) to face the electronic component (113);
arranging (S600) the second main side (202) against a cooling flange (203, 303) that is adapted to absorb heat from the thermal pad (202); and
securing (S700) the components of the PCB arrangement (250, 350) by pressing the thermal pad (200) between the PCB (110, 310) and the cooling flange (203, 303) such that a first shortest distance (h₁) between the first main side (201) and the second main side (202) decreases to a second shortest distance (h₂) between the first main side (201) and the second main side (202) .

15. The method according to claim 14, wherein the method comprises
arranging (S610) the thermal pad (200) on the second component side (112, 312) of the PCB (110, 310).
